# EUROPÄISCHE PATENTSCHRIFT

(11) **EP 2 041 808 B1**
(45) Veröffentlichungstag und Bekanntmachung des Hinweises auf die Patenterteilung: **31.03.2010**
(21) Anmeldenummer: 07730294.1
(22) Anmeldetag: 21.06.2007
(51) Int. Cl.: H01L 39/16, H02H 9/02

(54) **SUPRALEITENDE STROMBEGRENZEREINRICHTUNG VOM RESISTIVEN TYP MIT HALTEELEMENT**
SUPERCONDUCTING CURRENT-LIMITING DEVICE OF THE RESISTIVE TYPE WITH HOLDING ELEMENT
DISPOSITIF LIMITEUR DE COURANT SUPRACONDUCTEUR DU TYPE RÉSISTIF AVEC ÉLÉMENT DE SUPPORT

(30) Priorität: 17.07.2006 DE 102006032973
(43) Veröffentlichungstag der Anmeldung: 01.04.2009
(73) Patentinhaber: SIEMENS AKTIENGESELLSCHAFT, 80333 München (DE)
(72) Erfinder: KRÄMER, Hans-Peter, 91058 Erlangen (DE); WOHLFART, Manfred, 91369 Wiesenthau (DE)
(86) Internationale Anmeldenummer: PCT/EP2007/056217
(87) Internationale Veröffentlichungsnummer: WO 2008/009537

(56) Entgegenhaltungen:
- EP-A- 0 503 448
- WO-A-2004/006345
- WO-A-2006/037741

## Beschreibung

Die Erfindung bezieht sich auf eine supraleitende Strombegrenzereinrichtung vom resistiven Typ, deren Leiterbahn mit mindestens einem bandförmigen Supraleiter gebildet ist, wobei zwischen benachbarten Spulenwindungen ein Halteelement angeordnet ist.

Zum Schutz elektrischer Bauteile lässt sich unter Verwendung eines Supraleiters eine Strombegrenzereinrichtung aufbauen. Charakteristisch für Supraleiter ist die Eigenschaft, dass sie unterhalb einer materialspezifischen kritischen Temperatur Ströme praktisch ohne Widerstand tragen können, solange die Stromdichte kleiner ist als die von der Betriebstemperatur abhängige kritische Stromdichte. Diese kritische Stromdichte nimmt mit zunehmender Betriebstemperatur ab und wird zu null, wenn die Betriebstemperatur die erwähnte kritische Temperatur erreicht.

Dieses Phänomen lässt sich zum Aufbau einer Strombegrenzungseinrichtung ausnutzen, welche in dem Fall, dass die zuvor erwähnte kritische Stromdichte überschritten wird, ihren elektrischen Widerstand sprunghaft erhöht und sich durch die dann auftretenden Ohmschen Verluste bis über die kritische Temperatur erwärmt.

Um eine Zerstörung durch Überhitzen zu vermeiden, muss nach einem Ansprechen des Strombegrenzers der Strom abgeschaltet werden. Für die Wiederinbetriebnahme muss gewartet werden, bis der gesamte Begrenzer wieder auf die Betriebstemperatur abgekühlt ist. Diese Rückkühlzeit hat wesentlichen Einfluss auf die Verfügbarkeit des Strombegrenzers.

Unter Ausnutzung dieses Phänomens lässt sich ein Überstromschutzschalter (Strombegrenzer) realisieren, welcher sich durch schnelle Schaltzeiten und einen für die Schutzeinrichtung selbst nicht destruktiven Schaltvorgang auszeichnet. Entsprechende Strombegrenzereinrichtungen ist z.B. aus DE 10 2004 048 646 A1 bekannt.

Als Leiterbahn in einem solchen Strombegrenzer werden insbesondere supraleitende Bandleiter (coated conductors) verwendet. Unter einem supraleitenden Bandleiter ist in diesem Zusammenhang ein Aufbau zu verstehen, bei dem auf ein normalleitendes Substratmetall in Bandform eine supraleitende Schicht, typischerweise ein oxidischer Hochtemperatur-Supraleiter, aufgebracht wird. Zur Vermeidung von Induktivitäten wird der supraleitende Bandleiter in eine flache, bifilar gewickelte Spule eingebracht. Zwischen benachbarten Spulenwindungen ist ein Mindestabstand einzuhalten, so dass die Spule von einem Kühlmittel durchströmbar ist. Wird für den supraleitender Bandleiter ein Hochtemperatur-Supraleiter verwendet (z.B. YBCO), so ist flüssiger Stickstoff als Kühlmittel für die Strombegrenzereinrichtung geeignet.

Bei bifilar gewickelten Spulen aus Bandleitermaterial liegt nun im Bereich des äußeren Radius zwischen benachbarten Leiterbahnen die gesamte an der Spule abfallende Spannung an. Um eine möglichst kompakte Bauform der supraleitenden Strombegrenzereinrichtung zu ermöglichen, ist es wünschenswert, benachbarte Leiterwindungen auf möglichst geringem Raum unterzubringen. Folglich ist zum Schutz vor elektrischen Überschlägen eine möglichst gute Isolation zwischen benachbarten Windungen erforderlich. Gleichzeitig wird die Verfügbarkeit der supraleitenden Strombegrenzereinrichtung maßgeblich von der Rückkühlzeit des Supraleiters nach dem Schaltvorgang beeinflusst. Folglich ist eine gute Zugänglichkeit des Kältemittels zu der Leiterbahn des Strombegrenzers wünschenswert. Eine supraleitende Strombegrenzereinrichtung sollte sich weiterhin durch eine möglichst geringe Induktivität auszeichnen. Zu diesem Zweck ist es vorteilhaft, wenn benachbarte Windungen in axialer Richtung der Spule möglichst ideal auf einer gemeinsamen planen Fläche zu liegen kommen. Zu diesem Zweck ist eine exakte Positionierung der Windungen des supraleitenden Strombegrenzers wünschenswert.

Aufgabe der vorliegenden Erfindung ist es nun, eine supraleitende Strombegrenzereinrichtung vom resistiven Typ anzugeben, welche eine Verbesserung im Hinblick auf die zuvor genannten technischen Probleme darstellt.

Die vorgenannte Aufgabe wird mit den in Anspruch 1 angegebenen Maßnahmen gelöst. Demgemäß soll eine besondere supraleitende Strombegrenzereinrichtung vom resistiven Typ angegeben werden deren Leiterbahn mit einem bandförmigen Supraleiter gebildet ist. Zwischen benachbarten Spulenwindungen soll ein Halteelement angeordnet sein. Dieses Halteelement soll in axialer Richtung der Spule breiter als der bandförmige Supraleiter ausgebildet sein und aus einem Flachband und einem gewellten Band bestehen. Das Flachband soll sich im Wesentlichen parallel zu dem bandförmigen Supraleiter unter einem im Wesentlichen konstanten Abstand erstrecken. Das Flachband ist zumindest weitgehend nicht gewellt. Das gewellte Band soll sich im Wesentlichen parallel zu dem Flachband erstrecken, wobei das gewellte Band in seiner Längsrichtung periodisch radial von dem Flachband entfernte und dem Flachband nahe Bereiche aufweist. Die dem Flachband nahen Bereiche des gewellten Bandes sollen eine mechanische Verbindung mit dem Flachband aufweisen. Die dem Flachband fernen Bereiche des gewellten Bandes sollen Aussparungen aufweisen, so dass eine zumindest näherungsweise passgenaue, gegenüber dem Flachband beabstandete Aufnahme des bandförmigen Supraleiters ermöglicht ist.

Mit den erfindungsgemäßen Maßnahmen sind die folgenden Vorteile verbunden: Das Halteelement, bestehend aus dem Flachband und dem gewellten Band, ist in axialer Richtung breiter ausgebildet als der bandförmige Supraleiter. Auf diese Weise kann die elektrische Durchschlagstrecke von einer Spulenwindung zur nächsten gegenüber einer Ausführung, bei der das Halteelement die gleiche Breite wie der bandförmige Supraleiter aufweist, verlängert werden. Vorteilhaft wird auf diese Weise eine kompakte Bauform der Strombegrenzereinrichtung bei gleichzeitiger Verbesserung des Schutzes vor Spannungsüberschlägen realisiert. Durch eine Ausgestaltung des Halteelements, bestehend aus einem Flachband und einem gewellten Band, kann weiterhin eine hohe Permeabilität der Spule für ein den bandförmigen Supraleiter kühlendes Kältemedium erreicht werden. Auf diese Weise kann die Rückkühlzeit des supraleitenden Bandleiters minimiert werden. Der supraleitende Bandleiter soll von Aussparungen des gewellten Bandes zumindest näherungsweise passgenau aufgenommen werden. Auf diese Weise wird eine Fixierung des supraleitenden Bandleiters in axialer Richtung der Spule ermöglicht. Diese Fixierung trägt zur Minimierung der Induktivität der Spule bei. Durch die exakte axiale Positionierung der Windungen der Spule werden sowohl die Induktivität der Spule als auch die zwischen benachbarten Windungen wirkenden Lorentzkräfte minimiert. Vorteilhaft können auf diese Weise sowohl mechanische Belastungen, welche auf die eventuell vorhandenen Trageelemente der Wicklung wirken, als auch die Gesamtinduktivität der supraleitenden Strombegrenzereinrichtungen minimiert werden.

Vorteilhafte Ausgestaltungen der erfindungsgemäßen Strombegrenzereinrichtung gehen aus den von Anspruch 1 abhängigen Ansprüchen hervor. Dabei kann die Ausführungsform nach Anspruch 1 mit den Merkmalen eines Unteranspruches oder auch vorzugsweise mit denen aus mehreren Unteransprüchen kombiniert werden. Demgemäß kann die supraleitende Strombegrenzereinrichtung zusätzlich noch folgende Merkmale aufweisen:
- Die Spule der Strombegrenzereinrichtung soll als bifilar gewickelte Spule ausgestaltet sein. Bei einer bifilar gewickelten Spule kompensieren sich die Induktivitäten der beiden Hälften der bifilaren Wicklung. Auf diese Weise kann für einen Strombegrenzer vorteilhaft eine kompakte Bauform bei minimierter Induktivität erreicht werden.
- Für das Flachband und/oder das gewellte Band des Halteelementes ist ein elektrischer Isolator als Material vorgesehen. Vorteilhaft kann durch die Verwendung eines elektrisch isolierenden Materials für zumindest Teile der Haltevorrichtung die Gefahr von elektrischen Überschlägen zwischen den einzelnen Windungen der Spule minimiert werden.
- Als elektrischer Isolator ist ein Kunststoff vorgesehen. Vorteilhaft wirkt ein Kunststoff als elektrischer Isolator, und stellt zusätzlich aufgrund seiner verhältnismäßig geringen Wärmekapazität eine geringe thermische Last beim Einkühlvorgang der Strombegrenzereinrichtung dar.
- Das gewellte Band kann im Wesentlichen trapezförmig, sägezahnförmig oder sinusförmig ausgebildet sein. Vorteilhaft weist eine trapezförmige Ausgestaltung des gewellten Bandes eine mechanisch stabile Führung des supraleitenden Bandleiters in radialer Richtung auf. Eine sägezahnförmige oder sinusförmige Ausgestaltung des gewellten Bandes ist insbesondere in Bezug auf dessen Herstellung einfach und daher vorteilhaft.
- Als supraleitendes Material des bandförmigen Supraleiters ist HTS-Material (oxidisches Hochtemperatur-Supraleitermaterial) oder LTS-Material (metallisches Tieftemperatur-Supraleitermaterial) vorgesehen. Durch die Verwendung von oxidischem Hochtemperatur-Supraleitermaterial kann für die Kühlung der supraleitenden Strombegrenzereinrichtung vorteilhaft flüssiger Stickstoff als Kältemedium verwendet werden. Metallisches Tieftemperatur-Supraleitermaterial weist eine hohe mechanische Belastbarkeit auf und ist infolge dessen gut zu verarbeiten. Eine hohe mechanische Widerstandsfähigkeit führt weiterhin zu einer geringen Störanfälligkeit der supraleitenden Strombegrenzereinrichtung.
- Der bandförmige Supraleiter soll durch eine auf eine Puffer- oder Zwischenschicht, welche selbst auf einem normalleitenden metallischen Substratband aufgebracht ist, aufgebrachte Schicht von oxidischem Supraleitermaterial vom Typ AB₂Cu₃Oₓ gebildet sein, wobei A mindestens ein Seltenes Erdmetall einschließlich Yttrium und B mindestens ein Erdalkalimetall ist. Die Verwendung eines supraleitenden Bandleiters der zweiten Generation auf der Basis von Yttrium-Barium-Kupferoxid in einer supraleitenden Strombegrenzereinrichtung ist sowohl im Hinblick auf die Verarbeitung des weiterhin kommerziell gut verfügbaren bandförmigen Supraleiters der zweiten Generation wie auch im Hinblick auf den Schaltvorgang der supraleitenden Strombegrenzereinrichtung vorteilhaft.
- In der Spule wird der bandförmige Supraleiter zweckmäßig mit seiner Substratseite nach außen angeordnet. Eine auf einem metallischen Substratband aufgebrachte supraleitende Schicht weist typischerweise eine höhere mechanische Belastbarkeit für Druckspannungen als für Zugspannungen auf. Indem der supraleitende Bandleiter mit der Substratseite nach außen, also mit der beschichteten Seite nach innen, gewickelt wird ist die supraleitende Schicht vorzugsweise Druckspannungen ausgesetzt. Auf diese Weise kann vorteilhaft eine die supraleitenden Eigenschaften zerstörende Rissbildung innerhalb der supraleitenden Schicht verringert werden. Dies führt zu einer verbesserten Zuverlässigkeit der Strombegrenzereinrichtung.
- Der bandförmige Supraleiter und das Halteelement können mittels eines Kunstharzes unter Freihaltung von Kühlmittelwegen miteinander verklebt werden. Vorteilhaft wird durch eine Verklebung des supraleitenden Bandleiters mit dem Halteelement eine verbesserte Fixierung des Bandleiters am Halteelement erreicht. Auf diese Weise kann die Induktivität der Gesamtspule bzw. die zwischen benachbarten Windungen der Spule wirkenden Lorentzkräfte minimiert werden.
- Das Halteelement soll derart ausgestaltet sein, dass der gegenseitige Abstand zwischen den Spulenwindungen mindestens 1 mm beträgt. Vorteilhaft kann durch die Einhaltung dieses Mindestabstandes im Falle eines Schaltvorgänges siedendes Kältemittel zwischen den einzelnen Windungen der Spule entweichen, ohne eine unnötig große mechanische Belastung auf die tragende Struktur der Spule auszuüben. Ferner wird durch Einhaltung dieses Mindestabstandes eine hinreichende Kühlmittelversorgung des supraleitenden Bandleiters gewährleistet.

Weitere vorteilhafte Ausgestaltungen der erfindungsgemäßen supraleitenden Strombegrenzereinrichtungen gehen aus den vorstehend nicht angesprochenen Unteransprüchen sowie insbesondere aus der Zeichnung hervor.

Die Erfindung wird nachfolgend unter Bezugnahme auf die Zeichnung weiter erläutert, aus der bevorzugt Ausführungsbeispiele einer erfindungsgemäßen supraleitenden Strombegrenzereinrichtung ohne eine Einschränkung auf die konkret veranschaulichten Ausführungsformen hervorgehen. Dabei zeigen deren
- Figur 1: in Schrägsicht ein Halteelement und den darin angebrachten supraleitenden Bandleiter, wobei das Halteelement trapezförmig ausgestaltet ist,
- Figur 2: einen Längsschnitt durch das trapezförmig ausgeformte Halteelement nach Figur 1,
- Figur 3: einen Querschnitt durch das trapezförmig ausgeformte Halteelement nach Figur 1,
- Figur 4: einen Längsschnitt durch ein sinusförmig ausgeformtes Halteelement,
- Figur 5: einen Längsschnitt durch ein Halteelement, bei dem das gewellte Band sägezahnförmig ausgestaltet ist,
- Figur 6: in Aufsicht eine bifilar gewickelte Scheibenspule einer Strombegrenzereinrichtung.

In den Figuren sind sich entsprechende Teile mit denselben Bezugszeichen versehen.

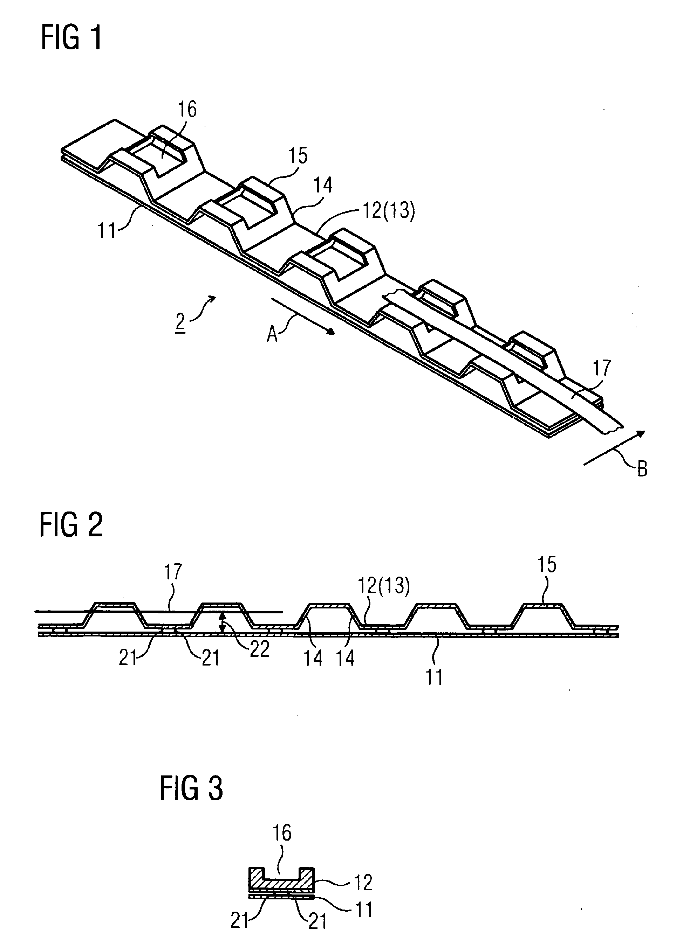

Figur 1 zeigt ein allgemein mit 2 bezeichnetes Halteelement, bestehend aus einem nicht gewellten Flachband 11 und einem trapezförmig ausgestalteten gewellten Band 12. Das trapezförmig ausgestaltete, somit gewellte Band weist hierbei dem Flachband 11 nahe Bereiche 13 und dem Flachband 11 entfernte Bereiche 15 auf. Die dem Flachband nahen und fernen Bereiche (13 bzw. 15) sind durch Verbindungs- oder Übergangsstücke 14 miteinander verbunden. Als dem Flachband 11 nahe bzw. ferne Bereiche (13 bzw. 15) des gewellten Bandes 12, des in Figur 1 dargestellten Halteelementes 2, sind nicht nur die mit 13 bzw. 15 bezeichneten Flächen der Trapeze zu verstehen, sondern auch entsprechende an diese Flächen anschließende Teile der Verbindungselemente 14. Die dem Flachband 11 entfernten Teile 15 des gewellten Bandes 12 weisen in Längsrichtung des gewellten Bandes 12 Aussparungen 16 auf. Diese sind derart ausgestaltet, dass in ihnen ein supraleitender Bandleiter 17 zumindest näherungsweise passgenau zu liegen kommt.

In Bezug auf die Verwendung eines in Figur 1 dargestellten und allgemein mit 2 bezeichneten Halteelements in einer Spule einer supraleitenden Strombegrenzereinrichtung, ist die in Figur 1 mit B bezeichnete Richtung die axiale Richtung der Spule und die mit A bezeichnete Richtung eine tangentiale Richtung der Spule. Die Strombegrenzereinrichtung kann aus einer oder mehreren Spulen bestehen, die in axialer Richtung B hintereinander angeordnet sind. Die einzelnen Spulen einer solchen Strombegrenzereinrichtung können als einfach oder bevorzugt als bifilar gewickelte Spulen ausgeführt sein.

Das im Allgemeinen mit 2 bezeichnete Halteelement kann aus verschiedenen geeigneten Materialien gefertigt sein. Vorteilhaft können das Flachband 11 und das gewellte Band 12 aus demselben oder aus unterschiedlichem Material bestehen. Hierbei können beide Bauteile z.B. aus einem Kunststoff gefertigt sein. Der supraleitende Bandleiter 17 kann aus Gründen der mechanischen Stabilisierung mit dem gewellten Band 12 mechanisch verbunden werden. Vorteilhaft ist eine Verklebung des Bandleiters 17 im Bereich der Kontaktflächen mit dem gewellten Band 12 oder auch eine Verbindung mittels Löt- oder Schweißpunkten oder Nähten. Bei einer Ausgestaltung des Halteelementes 2 unter Verwendung zweier verschiedener Materialien kann das Flachband 11 auftretende mechanische Belastungen sowohl in die mit A wie auch in die mit B bezeichnete Richtung aufnehmen. Das gewählte Band 12 wirkt zusätzlich als elektrischer Isolator.

Weiterhin vorteilhaft ist die derartige Ausgestaltung des Halteelementes 2, dass dieses in axialer Richtung der Spule (in Figur 1 mit B bezeichnet) eine größere Ausdehnung als der supraleitende Bandleiter 17 aufweist. Auf diese Weise wird die Strecke für einen möglichen elektrischen Überschlag von einer Spulenwindung zur nächsten, im Vergleich zu einem Halteelement 2, das in Richtung B die gleiche Breite wie der supraleitende Bandleiter 17 aufweist, deutlich verlängert. Auf diese Weise sinkt die Gefahr für unerwünschte elektrische Überschläge zwischen den Windungen der Spule.

Eine exakte Positionierung der Aussparungen 16 in der Richtung B sorgt für eine exakte Positionierung des Bandleiters 17 in diese Richtung. Eine solche Positionierung des Bandleiters 17 erlaubt wiederum eine Minimierung der Induktivität der Spule. Wird die Spule als bifilare Spule ausgeführt, so ermöglicht eine solche exakte Positionierung eine verbesserte Kompensation der magnetischen Induktivitäten zwischen den beiden Teilen der bifilaren Wicklung. Die Lorentzkräfte zwischen benachbarten Windungen können auf diese Weise, als Folge einer exakten Positionierbarkeit in der Richtung B, minimiert werden.

Figur 2 zeigt einen Längsschnitt durch das in Figur 1 gezeigte Halteelement 2. Gemäß diesem Ausführungsbeispiel befindet sich der bandförmige Supraleiter 17, gehalten durch das gewellte Band 12, in einem im Wesentlichen konstanten Abstand 22 zum Flachband 11. Das gewellte Band 12 ist über Verbindungselemente 21 mit dem Flachband 11 verbunden. Vorteilhaft können die Verbindungselemente 21 als Stege, Schweißpunkte, Klebepunkte oder ähnliches ausgeführt sein.

Figur 3 zeigt einen Querschnitt durch das Halteelement 2 gemäß der in Figur 1 gezeigten bevorzugten Ausführungsform. Dargestellt sind sowohl das Flachband 11 wie auch das gewellte Band 12, welches eine Aussparung 16 aufweist. Das Flachband 11 und das gewellte Band 12 sind über die Verbindungselemente 21 miteinander verbunden. Die Ausführungsform der Verbindungselemente 21 ist hierbei nicht auf eine punktuelle Verbindung von Flachband 11 und gewellten Band 12 beschränkt; auch eine teilweise flächige Verbindung zwischen den Elementen 11 und 12 ist vorteilhaft realisierbar.

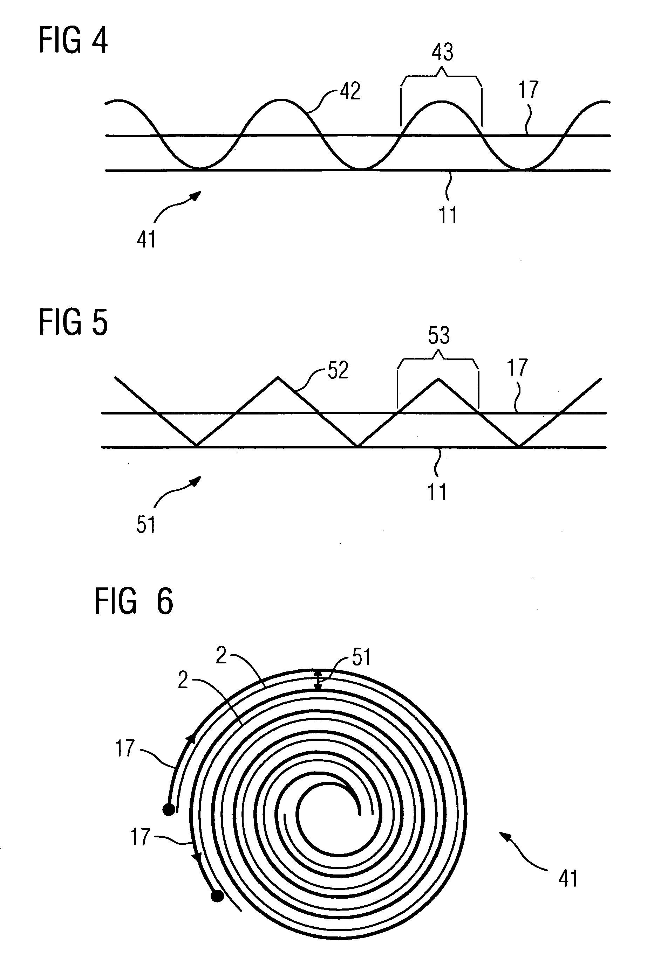

Figur 4 zeigt ein weiteres bevorzugtes Ausführungsbeispiel eines Halteelementes 41 einer supraleitenden Strombegrenzereinrichtung, dargestellt in einem Längsschnitt. Das gewellte Band 42 ist gemäß diesem Ausführungsbeispiel sinusförmig ausgestaltet und weist in den dem Flachband 11 entfernten Teilbereichen 43 Aussparungen zur Aufnahme des supraleitenden Bandleiters 17 auf.

Gemäß einem weiteren in Figur 5 dargestellten bevorzugten Ausführungsbeispiel eines Halteelementes 51 kann das gewellte Band 52 sägezahnförmig, insbesondere in der Form einer periodischen Dreiecksstruktur ausgebildet sein. Gemäß diesem Ausführungsbeispiel verfügt das gewellte Band 52 in den dem Flachband 11 entfernten Bereichen 53 Aussparungen zur Aufnahme des supraleitenden Bandleiters 17 auf.

Ebenfalls vorteilhaft realisierbar sind weitere geometrische Ausgestaltungsformen des gewellten Bandes 12, 42, 52 welche nicht explizit in den vorgenannten Figuren dargestellt sind, sich aber z.B. aus einer Kombination der dargestellten Formen ergeben.

Figur 6 zeigt den bifilaren Aufbau einer Scheibenspule 61 gemäß einem bevorzugten Ausführungsbeispiel der supraleitenden Strombegrenzereinrichtung. Dargestellt sind der bifilar gewickelte supraleitende Bandleiter 17 sowie ein zwischen den Windungen angeordnetes Halteelement 2. Diese Halteelement 2 kann entsprechend einer der zuvor erwähnten Figuren ausgestaltet sein.

Gemäß einem bevorzugten Ausführungsbeispiel kann der supraleitende Bandleiter 17 mit der supraleitenden Schicht zur Spuleninnenseite gewickelt sein, da z.B. oxidische Hochtemperatur-Supraleiterschichten stärker auf Druck als auf Zug belastbar sind. Der supraleitende Bandleiter 17 kann ferner wie folgt aufgebaut sein.

Auf einem metallischen Substratband kann zunächst eine so genannte Pufferschicht aufgebracht sein, auf welcher die eigentlich supraleitende oxidische Hochtemperatur-Supraleiterschicht (z.B. YBCO) aufgebracht ist. Der Aufbau solcher für supraleitende Strombegrenzereinrichtungen geeigneten Bandleiter ist z.B. in DE 10 2004 048 646 A1 vorgeschlagen. Der gesamte mechanische Aufbau der Windungen der Spule muss hinreichend mechanisch stabil sein, d.h. er muss bei der Montage handhabbar sein und muss die beim Sieden des Kühlmittels auftretenden Kräfte ohne weiteres aufnehmen können. Einfluss auf die bei einem Sieden des Kühlmittels auftretenden Kräfte hat der von der Dimensionierung des Halteelementes 62 abhängige Abstand 63 der Leiterwicklungen 17 (vgl. Figur 6). In Bezug auf das in Figur 2 dargestellte Halteelement 2 wird dieser Abstand insbesondere durch den Abstand 22 des supraleitenden Bandleiters 17 zu dem Flachband 11, sowie der Gesamthöhe 23 des Halteelementes vorgegeben.

## Patentansprüche

1. Supraleitende Strombegrenzereinrichtung vom resistiven Typ mit mindestens einer Spule, deren Leiterbahn mit mindestens einem bandförmigen Supraleiter (17) gebildet ist, wobei zwischen benachbarten Spulenwindungen ein Halteelement (2, 41, 51, 62) angeordnet ist, welches in axialer Richtung der Spule breiter als der Supraleiter (17) ausgebildet ist und welches aus einem Flachband (11) und einem gewellten Band (12, 42, 52) besteht, wobei
a. sich das Flachband (11) parallel zu dem bandförmigen Supraleiter (17) unter im wesentlichen konstantem Abstand erstreckt, und
b. das gewellte Band (12, 42, 52) sich im Wesentlichen parallel zu dem Flachband (11) erstreckt, wobei das gewellte Band (12, 42, 52) in seiner Längsrichtung periodisch von dem Flachband entfernte (15, 43, 53) und dem Flachband nahe (13) Bereiche aufweist, wobei b1. die dem Flachband nahen Bereiche (13) des gewellten Bandes (12, 42, 52) eine mechanische Verbindung (21) mit dem Flachband (11) aufweisen, und **dadurch gekennzeichnet, dass** b2. die dem Flachband fernen Bereiche (15, 43, 53) des gewellten Bandes solche Aussparungen (16) aufweisen, dass eine zumindest näherungsweise passgenaue, gegenüber dem Flachband (11) beabstandete Aufnahme des bandförmigen Supraleiters (17) ermöglicht ist.

2. Supraleitende Strombegrenzereinrichtung gemäß Anspruch 1, **dadurch gekennzeichnet, dass** für die Spule (61) eine bifilare Wicklung des Supraleiters (17) vorgesehen ist.

3. Supraleitende Strombegrenzereinrichtung gemäß einem der vorstehenden Ansprüche, **dadurch gekennzeichnet, dass** als Material für das Flachband (11) und/oder das gewellte Band (12, 42, 52) ein elektrischer Isolator vorgesehen ist.

4. Supraleitende Strombegrenzereinrichtung gemäß Anspruch 3, **dadurch gekennzeichnet, dass** der elektrische Isolator ein Kunststoff ist.

5. Supraleitende Strombegrenzereinrichtung gemäß einem der vorstehenden Ansprüche, **dadurch gekennzeichnet, dass** das gewellte Band (12, 42, 52) im Wesentlichen trapezförmig, sägezahnförmig oder sinusförmig ausgebildet ist.

6. Supraleitende Strombegrenzereinrichtung gemäß einem der vorstehenden Ansprüche, **dadurch gekennzeichnet, dass** als supraleitendes Material des bandförmigen Supraleiters (17) ein HTS-Material oder ein LTS-Material vorgesehen ist.

7. Supraleitende Strombegrenzereinrichtung gemäß Anspruch 6, **dadurch gekennzeichnet, dass** der bandförmige Supraleiter (17) durch eine auf eine Puffer oder Zwischenschicht, welche selbst auf ein normalleitendes metallisches Substratband aufgebracht ist, aufgebrachte Schicht von oxidischem Supraleitermaterial vom Typ AB₂Cu₃Oₓ gebildet ist, wobei A mindestens ein seltenes Erdmetall einschließlich Yttrium und B mindestens ein Erdalkalimetall ist.

8. Supraleitende Strombegrenzereinrichtung gemäß einem der vorstehenden Ansprüche, **dadurch gekennzeichnet, dass** in der Spule (61) der bandförmige Supraleiter (17) mit seiner Substratseite nach außen angeordnet ist.

9. Supraleitende Strombegrenzereinrichtung gemäß einem der vorstehenden Ansprüche, **dadurch gekennzeichnet, dass** der bandförmige Supraleiter (17) und das Halteelement (2, 41, 51, 62) mittels eines Kunstharzes unter Freihaltung von Kühlmittelwegen miteinander verklebt sind.

10. Supraleitende Strombegrenzereinrichtung gemäß einem der vorstehenden Ansprüche, **dadurch gekennzeichnet, dass** das Halteelement (2, 41, 51, 62) derart ausgestaltet ist, dass der gegenseitige Abstand (63) zwischen den Spulenwindungen mindestens 1 mm beträgt.

## Claims

1. Superconducting current limiter device of the resistive type, having at least one coil whose conductive track is formed by at least one band-shaped superconductor (17), a holding element (2, 41, 51, 62) being arranged between neighboring coil turns, which holding element is designed to be wider than the superconductor (17) in the axial direction of the coil and consists of a flat band (11) and a corrugated band (12, 42, 52), wherein
a. the flat band (11) extends parallel to the band-shaped superconductor (17) with an essentially constant spacing, and
b. the corrugated band (12, 42, 52) extends essentially parallel to the flat band (11), the corrugated band (12, 42, 52) having regions (15, 43, 53) away from the flat band and regions (13) close to the flat band periodically in its longitudinal direction,
b1. the regions (13) of the corrugated band (12, 42, 52) which lie close to the flat band having a mechanical connection (21) to the flat band (11), and **characterized in that**
b2. the regions (15, 43, 53) of the corrugated band which lie away from the flat band have recesses (16) so as to allow at least approximately tight-fit reception of the band-shaped superconductor (17) at a distance from the flat band (11).

2. Superconducting current limiter device as claimed in Claim 1, **characterized in that** double winding of the superconductor (17) is provided for the coil (61).

3. Superconducting current limiter device as claimed in one of the preceding claims, **characterized in that** an electrical insulator is provided as the material for the flat band (11) and/or the corrugated band (12, 42, 52).

4. Superconducting current limiter device as claimed in Claim 3, **characterized in that** the electrical insulator is a plastic.

5. Superconducting current limiter device as claimed in one of the preceding claims, **characterized in that** the corrugated band (12, 42, 52) is essentially designed trapezoidally, in a sawtooth shape or sinusoidally.

6. Superconducting current limiter device as claimed in one of the preceding claims, **characterized in that** an HTS material or an LTS material is provided as the superconducting material of the band-shaped superconductor (17).

7. Superconducting current limiter device as claimed in Claim 6, **characterized in that** the band-shaped superconductor (17) is formed by a layer of oxidic superconductor material of the Ab₂Cu₃Oₓ type applied onto a buffer or interlayer, which is itself applied onto a metallic substrate band, where A is at least one rare earth metal inclusive of yttrium and B is at least one alkaline-earth metal.

8. Superconducting current limiter device as claimed in one of the preceding claims, **characterized in that** the band-shaped superconductor (17) is arranged with its substrate side outward in the coil (61).

9. Superconducting current limiter device as claimed in one of the preceding claims, **characterized in that** the band-shaped superconductor (17) and the holding element (2, 41, 51, 62) are adhesively bonded to one another by means of a synthetic resin while keeping refrigerant paths free.

10. Superconducting current limiter device as claimed in one of the preceding claims, **characterized in that** the holding element (2, 41, 51, 62) is configured so that the mutual spacing (63) between the superconducting turns is at least 1 mm.

## Revendications

1. Dispositif limiteur de courant supraconducteur du type résistif ayant au moins une bobine dont la piste conductrice est formée par au moins un supraconducteur ( 17 ) en forme de ruban, un élément ( 2, 41, 51, 62 ) de maintien étant disposé entre des spires voisines de bobine, élément qui est plus large dans la direction axiale de la bobine que le supraconducteur ( 17 ) et qui est constitué d'un ruban ( 11 ) plat et d'un ruban ( 12, 42, 52 ) ondulé, dans lequel
a. le ruban ( 11 ) plat s'étend parallèlement au supraconducteur ( 17 ) en forme de ruban à une distance sensiblement constante, et
b. le ruban ( 12, 42, 52 ) ondulé s'étend sensiblement parallèlement au ruban ( 11 ) plat, le ruban ( 12, 42, 52 ) ondulé ayant dans sa direction longitudinale des parties périodiquement éloignées ( 15, 43, 53 ) du ruban plat et proches ( 13 ) du ruban plat, dans lequel
b1. des parties ( 13 ) du ruban ( 12, 42, 52 ), qui sont proches du ruban plat, ont une liaison ( 21 ) mécanique avec le ruban ( 11 ) plat, et
**caractérisé en ce que**
b2. les parties ( 15, 43, 53 ) du ruban ondulé, qui sont éloignées du ruban plat, ont des évidements ( 16 ) tels qu'une réception, adaptée au moins approximativement de manière précise et à distance du ruban ( 11 ) plat, du supraconducteur ( 17 ) en forme de ruban, soit rendue possible.

2. Dispositif limiteur de courant supraconducteur suivant la revendication 1, **caractérisé en ce qu'**il est prévu, pour la bobine ( 61 ), un enroulement bifilaire du supraconducteur ( 17 ).

3. Dispositif limiteur de courant supraconducteur suivant l'une des revendications précédentes, **caractérisé en ce qu'**il prévu, comme matériau pour le ruban ( 11 ) plat et/ou le ruban ( 12, 42, 52 ) ondulé, un isolant électrique.

4. Dispositif limiteur de courant supraconducteur suivant la revendication 3, **caractérisé en ce que** l'isolant électrique est une matière plastique.

5. Dispositif limiteur de courant supraconducteur suivant l'une des revendications précédentes, **caractérisé en ce que** le ruban ( 12, 42, 52 ) ondulé est sensiblement trapézoïdal, en dents de scie ou sinusoïdal.

6. Dispositif limiteur de courant supraconducteur suivant l'une des revendications précédentes, **caractérisé en ce qu'**il est prévu comme matériau supraconducteur du supraconducteur ( 17 ) en forme de bande un matériau HTS ou un matériau LTS.

7. Dispositif limiteur de courant supraconducteur suivant la revendication 6, **caractérisé en ce que** le supraconducteur ( 17 ) en forme de ruban est formé par une couche de matériau supraconducteur oxydé du type AB₂Cu₃Oₓ déposée sur un tampon, une couche intermédiaire déposée soi-même sur un ruban métallique formant substrat normalement conducteur, A étant au moins un métal de terre rare, y compris l'yttrium, et B au moins un métal alcalino-terreux.

8. Dispositif limiteur de courant supraconducteur suivant l'une des revendications précédentes, **caractérisé en ce que** dans la bobine ( 61 ) le supraconducteur ( 17 ) en forme de ruban est disposé en ayant sa face de substrat vers l'extérieur.

9. Dispositif limiteur de courant supraconducteur suivant l'une des revendications précédentes, **caractérisé en ce que** le substrat conducteur ( 17 ) en forme de ruban et l'élément ( 2, 41, 51, 62 ) de maintien sont collés entre eux au moyen d'une résine synthétique en laissant libre des voies pour du fluide de refroidissement.

10. dispositif limiteur de courant supraconducteur suivant l'une des revendications précédentes, **caractérisé en ce que** l'élément ( 2, 41 51, 62 ) de maintien est tel que la distance ( 63 ) mutuelle entre les spires de l'enroulement soit d'au moins 1 mm.
